# Europäisches Patentamt

## European Patent Office

## Office européen des brevets

(19)

(11) Publication number: **0 037 877**
**B1**

(12)

# EUROPEAN PATENT SPECIFICATION

(45) Date of publication of patent specification: **19.09.84**

(51) Int. Cl.³: **H 01 L 41/18**

(21) Application number: **81100836.6**

(22) Date of filing: **05.02.81**

(54) Piezoelectric polymer material, process for producing the same and an ultrasonic transducer utilizing the same.

(30) Priority: **07.02.80 JP 13839/80**
**12.02.80 JP 15860/80**

(43) Date of publication of application:
**21.10.81 Bulletin 81/42**

(45) Publication of the grant of the patent:
**19.09.84 Bulletin 84/38**

(84) Designated Contracting States:
**CH DE FR GB LI NL**

(56) References cited:
**DE-A-2 738 220**
**FR-A-2 117 315**
**US-A-3 798 473**

(73) Proprietor: **TORAY INDUSTRIES, INC.**
**2, Nihonbashi Muromachi 2-chome Chuo-ku**
**Tokyo 103 (JP)**

(72) Inventor: **Ohigashi, Hiroji**
**1469-6, Hisagi 7**
**Zushi-shi Kanagawa-ken (JP)**
Inventor: **Koga, Keiko**
**4-12 Yutaka-cho**
**Sagamihara-shi Kanagawa-ken (JP)**
Inventor: **Nakanishi, Toshiharu**
**660-1, Tebiro**
**Kamakura-shi Kanagawa-ken (JP)**

(74) Representative: **Körner, Ekkehard, Dipl.-Ing.**
**et al**
**Patentanwälte Müller-Börner, Wey & Körner**
**Widenmayerstrasse 49**
**D-8000 München 22 (DE)**

Courier Press, Leamington Spa, England.

## Description

Background of the Invention
1. Field of the Invention
The present invention relates to a piezoelectric polymer material and a process for producing the same, and further an ultrasonic transducer utilized the same.

2. General Description of the Prior Art
A polymer film which becomes a piezoelectric polymer film by poling treatment is, as is disclosed in Japanese patent publication No. 26799/1978, capable of generating and receiving ultrasonic wave by utilizing its thickness vibration mode and being utilized as an ultrasonic transducer.

A piezoelectric polymer material not only has flexibility, being high in water resistance and impact resistance, but its area and shape are not substantially restricted, therefore, it has many merits compared with an inorganic single crystal or ceramic piezoelectric material. Further, the acoustic impedance of a piezoelectric polymer material is very close to those of water, plastics and an organism, said material functions as a transducer having a low Q value upon transmission and receipt of a sound wave to and from these substances, therefore, it becomes a transducer having a broad band, being by far a superior material to an inorganic piezoelectric material as a material for a transducer for diagnosing.

Of various factors determining the ratio of a mechanical power output to an electrical power input (or the ratio of an electrical power output to a mechanical power input) of an ultrasonic transducer, what a piezoelectric material depends on is mainly an electromechanical coupling factor $K_t$ concerning thickness vibration. Of the hitherto known piezoelectric polymer materials, the one which has the highest performance is a poled polyvinylidene fluoride (hereinafter referred to as PVDF) film. However, according to the study of the present inventors, the $K_t$ of PVDF is about 0.2 at present even if it is poled under good conditions, which is considerably smaller than the $K_t$ of piezoelectric ceramic material. It is difficult to prepare PVDF having a large $K_t$. Further, PVDF has large dielectric loss and mechanical loss at a practically important working frequency (not less than 1 MHz) in practical use of an ultrasonic transducer, and thus not only it is accompanied by generation of heat when it is electrically driven, but also lowering of efficiency is brought about. From these reasons, a piezoelectric transducer using PVDF is not ideal and appearance of a more efficient transducer has been earnestly wished.

With a view to developing a piezoelectric polymer ultrasonic transducer having a performance higher than that of an ultrasonic transducer using PVDF, we, the present inventors repeated studies. As a result, we found that a piezoelectric material obtained by poling a copolymer of vinylidene fluoride and ethylene trifluoride (hereinafter referred to as P(VDF—TrFE) has a very large $K_t$ value, and an ultrasonic transducer using the thickness vibration mode of the piezoelectric P(VDF—TrFE) is higher in performance than an ultrasonic transducer using PVDF.

The piezoelectric properties of P(VDF—TrFE) are described in Laid-open Japanese patent application No. 26995/1978 or Higashihata, Yagi, Sako on page 325; Uchidei, Iwama, Tamura on page 326; and Yamada, Ueda, Kitayama on page 326 of Manuscripts of speeches at the meeting of Applied Physics Society (April 1979 at Tokyo). Laid-open application no 26995/1978 has an equivalent DE—A—2738220 and discloses a range of piezoelectric copolymers from 100% PVDF to 100% PTrFE. However, this relates to piezoelectric properties ($d_{31}$) accompanied by expansion and contraction in a direction parallel to the film surface. The present invention differs in that the proportions of the monomers are selected so as to utilize deformation in a direction perpendicular to the film surface, namely, the piezoelectric properties ($e_{33}$) of P(VDF—TrFE) with respect to expansion and contraction of the film thickness. For information, it is most effective to use the piezoelectric properties in the vicinity of frequency where this thickness expansion and contraction vibration is substantially in a resonance state under circumstances decided by the electric and acoustic properties of the film per se and boundary conditions of the film. However, as occasion demands, it is possible to use the piezoelectric properties at a non-resonance frequency.

The terms transverse piezoelectric properties and thickness piezoelectric properties referred to herein are defined as follows. Namely, in a piezoelectric polymer film, the poling direction is perpendicular to the film surface and this direction is perpendicular to the film surface and this direction is made Z(3) axis. The axes of symmetry within the film surface are selected as X(1) axis and Y(2) axis. When the film is monoaxially drawn, this axis is made X(1) axis. At this time, the components of the piezoelectric d- constant are as follows.

$$d_{ij} = \begin{bmatrix} 0 & 0 & 0 & 0 & d_{15} & 0 \\ 0 & 0 & 0 & d_{24} & 0 & 0 \\ d_{31} & d_{32} & d_{33} & 0 & 0 & 0 \end{bmatrix}$$

**0 037 877**

The piezoelectric constants shown by $d_{31}$ and $d_{32}$ are related to the transverse piezoelectric properties and the piezoelectric constant shown by $d_{33}$ is related to thickness piezoelectric properties.

Summary of the Invention

It is an object of the present invention to provide a piezoelectric polymer material consisting solely or mainly of a copolymer of vinylidene fluoride and ethylene trifluoride (P(VDF—TrFE)) having a large thickness extensional electromechanical coupling factor ($K_t$).

It is a further object of the present invention to provide a process for producing a piezoelectric P(VDF—TrFE) film having a large $K_t$.

It is a still further object of the present invention to provide an ultrasonic transducer utilized a piezoelectric P(VDF—TrFE) film having a large $K_t$ as an electro-mechanical transducer element.

Other objects of the present invention subsequently will become apparent by reference to the following description in conjunction with the experimental data and the accompanying drawings.

In accordance with the present invention, a piezoelectric polymer material consisting solely or mainly of a copolymer consisting solely or mainly of 65 to 82 mol % of vinylidene fluoride and 35 to 18 mol % of ethylene trifluoride (P(VDF—TrFE)) has the value of the thickness extensional electromechanical coupling factor ($K_t$) of at least 0.05, preferably of at least 0.1 and more preferably of at least 0.2.

The thickness extensional electromechanical coupling factor ($K_t$) referred to herein is defined as follows.

$$K_t = \left[ \frac{e_{33}^2}{c_{33}^D \, \varepsilon_{33}^S} \right]^{1/2}$$

wherein

$e_{33}$: Piezoelectric (stress) constant.

$C_{33}^D$: Elastic constant under fixed electric displacement.

$\varepsilon_{33}^S$: Dielectric constant under fixed strain.

Suffix letter: Z(3) axis is selected perpendicular to the film surface and letters are added thereto.

The value of the $K_t$ is measured by applying a high frequency (1—50 MHz) in AC field at room temperature to an about 1 cm² circular of square film and analyzing the frequency characteristics of an electric admittance Y in the vicinity of a resonance region of the film. As to the details, refer to Journal of Applied Physics, Vol. 47, No. 3, March 1976, pages 949—955.

The value of the piezoelectric constant $d_{31}$ with respect to the transverse piezoelectric properties is sought by mechanically exciting a film at room temperature with 110 Hz by Vibron-II manufactured by Toyo Sokki Co., Ltd. of Japan and measuring the amount of AC electric charge generated on the film surface and the stress at the section of the film.

It is preferable that a piezoelectric polymer material of the present invention consists solely of P(VDF—TrFE), however, P(VDF—TrFE) may contain other copolymerization components such as, vinylidene chloride, acrylonitrile within the scope of not substantially remarkably affecting the piezoelectric effect.

In accordance with the present invention, a process for producing a piezoelectric polymer material which consists solely or mainly of a copolymer consisting solely or mainly of P(VDF—TrFE) and which has the value of $K_t$ of at least 0.05 comprises heat-treating a shaped article solely or mainly of a copolymer consisting solely or mainly of 65—82 mol %, more preferably 70—82 %, of vinylidene fluoride and 35—18 mol %, more preferably 30—18 mol %, of ethylene trifluoride at a heat-treating temperature T(°C) being in the range of from [crystal phase transition temperature $T_m'$ (°C) — 5(°C)] to [melting point temperature $T_m$(°C)] more being in the range of from [$T_m'$ (°C)] to [$T_m$ (°C)], and poling the heat-treated shaped article, or comprises poling the shaped article while heat-treating the same at the heat-treating temperature.

Where the shaped article does not show the crystal phase transition temperature $T_m'$, the shaped article should be heat-treated so as to show the $T_m'$ before poling, or should be heat-treated while poling so as to show the $T_m'$. Whether the shaped article of P(VDF—TrFE) possesses the $T_m'$ or not depends on a ratio of VDF and TrFE, a method of forming (such as melt extruding, melt casting, solvent casting, etc.) the shaped article, a cooling condition (such as rapid cooling, moderate cooling, etc.) after forming the shaped article, a forming condition while forming the shaped article, a drawing condition after forming the shaped article, a history of heat-treatment of the shaped article, etc.

The crystal phase transition temperature $T_m'$ is determined on a P(VDF—TrFE) DSC (differential scanning calorimetry) curve obtained by raising temperature at a rate of 10°C/min. The DSC curve shows an endothermic peak corresponding to the melting point and other one or more peak(s) or shoulder(s) at the range of temperature lower than the temperature of the melting point, if the shaped

3

article possesses. The $T_m'$ is determined with the temperature corresponding to the peak or shoulder which is the closest to the peak corresponding to the melting point.

In the following, in a process for producing a piezoelectric material according to the present invention, a process of subjecting the shaped article to a poling treatment while imparting a heat-treatment effect will be referred to as a direct poling method and a process of subjecting the shaped article to a poling treatment after heat-treating the shaped article will be referred to as a preheat-treating method.

Upon practicing a process for producing a piezoelectric polymer material according to the present invention, the larger is the poling electric field, the more it is preferable within the scope of not bringing about dielectric breakdown, and the longer is the poling time, the more it is preferable. However, when the actual production efficiency is taken into account, in the case of adopting the direct poling method, it is recommendable to select the poling voltage within the range of about 50—1000 KV/cm and the poling time within the range of about 1 minute-2 hours. On the other hand, in the case of adopting the preheat-treating method, it is recommendable to select the preheat-treatment time at least about 10 minutes, the poling voltage within the range of about 50—1500 KV/cm and the poling time within the range of about 1 minute-2 hours. In either of the aforesaid two cases, it is preferable from the viewpoint of retaining the shape of a produced piezoelectric polymer material to subject the shaped article under tension to a heat-treatment or poling treatment, however, when it is not necessary to particularly consider the point of retaining the shape, it is also possible to subject the film in a freely expanding or contracting state to a poling treatment, especially when the film is not preferentially oriented.

In a process for producing a piezoelectric polymer material according to the present invention, the preheat-treating method has the following advantages over the direct poling method. In either of the two methods, it is an indispensable requirement to impart the effect of a heat-treatment at a temperature of at least $(T_m' - 5)°C$ to the shaped article. Accordingly, in the direct poling method, the poling treatment at a high temperature is required by all means, however, the higher is the poling temperature, the lower becomes the dielectric breakdown voltage. Accordingly, it may become difficult to carry out the poling treatment at a high voltage. By contrast, in the preheat-treating method, because it is possible to separately select the heat-treatment temperature and the poling temperature, it has an advantage that when the poling treatment at a high voltage is required, it is possible to select as the poling temperature a low temperature to an extent of room temperature and produce a piezoelectric polymer material having good thickness piezoelectric properties that meet the object as the case may be. In the case where it is required to produce a piezoelectric polymer material by a poling treatment of the same together with the concomitant substrate thereof and it is difficult for this concomitant to withstand a high temperature, it is possible, according to the preheat-treating method, to produce a piezoelectric polymer material having good thickness properties together with its concomitant substrate by heat-treating the film at a high temperature in advance, annexing the film to a substrate and thereafter poling the film at a low temperature. Therefore, the preheat-treating method has an advantage in such case also.

In accordance with the present invention, an ultrasonic transducer comprises a piezoelectric vibration element comprising a sheet of piezoelectric copolymer of P(VDF—TrFE), the ratio of VDF/TrFE being within the range of 82/18—65/35 (mol%), more preferably 70/30—82/18 (mol%), which has the value of the thickness extensional electromechanical coupling factor ($K_t$) of at least 0.05, preferably of at least 0.1 and more preferably of at least 0.2 and which vibrates under thickness piezoelectric properties.

An ultrasonic transducer of hpjspresent invention may be used in a state of setting a film having electrodes on its both surfaces on a supporting frame in a stretched condition also, however, more generally, it is used in a state of being kept on a supporting base plate. It is possible to provide this supporting base plate on the front surface, rear surface or both of the two surfaces of the radiation (incidence) of a sound wave in accordance with the object and it goes without saying that the material, shape and thickness of this supporting base plate are selected in accordance with the object.

When a few examples thereof are stated, there are the following laminated structures from the rear surface to the front surface.

(a) A high polymer base plate/an electrode/a piezoelectric film/an electrode/an additional film

(b) A high polymer base plate/a reflective plate/an electrode/a piezoelectric film/an electrode/an additional film

(c) A reflective plate/an electrode/a piezoelectric film/an electrode/a high polymer block

(d) A metal plate (concurrently acting as an electrode)/a piezoelectric film/a metal foil (concurrently acting as an electrode)

(e) An electrode/a piezoelectric film/an electrode/a high polymer base plate

(f) An electrode/a polymer film/a piezoelectric film/an electrode wherein a reflective plate is a plate, whose acoustic impedance is large enough for the purpose of standing a vibrational mode of the piezoelectric film with its nodal point at a place close to the border between the reflective plate and the piezoelectric film and what is sufficiently thicker than the wavelength of the sound wave in said plate (at a working frequency) or what has about 1/4 wavelength is preferably used. However, a thinner plate having a thickness in an extent of about 1/16 wavelength may be used as well. In the case that the reflective plate is made of a metal, it may serve as an electrode as well. An additional film is a film provided for controlling the resonance frequency of a piezoelectric film and for serving also as a protecting film of an electrode as occasion demands and a high polymer film or a thin metal film is preferably used as an additional film.

The foregoing examples are a few examples of the structure and the structure is not limited thereto.

Further, in a transducer of the present invention, it is possible not only to use a single layer of the P(VDF—TrFE) piezoelectric vibrator, but also to laminate a plurality of piezoelectric vibrators in the same polarization direction or laminate the adjoining films whose polarization directions confront. In the case of the former, it is possible to use the transducer wherein an electrode is not inserted between the adjoining films and in the case of the latter, it is possible to use the transducer wherein an electrode is inserted therebetween. The structure of the former is effective for lowering the resonance frequency and increasing the electric impedance, while the structure of the latter is effective for lowering the resonance frequency and lowering the impedance.

A transducer of the present invention is not limited to the use of one electrode to a single piezoelectric film made of P(VDF—TrFE) or a set of laminated piezoelectric films but may use a structure wherein plural pairs of electrodes are provided. In spite of the fact that the piezoelectric constant of P(VDF—TrFE) has a large $K_t$ value, its $d_{31}$ (and $d_{32}$) being smaller than those of PVDF, its $K_{31}$ and $K_{32}$ are smaller, accordingly, in case plural pairs of electrodes are provided adjoiningly, an electric-acoustic interaction between the adjoining electrodes is small and there is a merit that an unnecessary signal due to said interaction may be depressed.

A transducer of the present invention is generally used for receiving and transmitting ultrasonic waves and it is used especially preferably as a transducer for a non-destruction test, above all, for ultrasonic diagnosis, especially for diagnosis of an organism. As the shape of the transducer, various shape are possible and there are, for example, a concave covergence type ultrasonic transducer or a liner array type transducer for electronic linear scanning, a phase array type transducer, a Fresnel ring type transducer or a two dimensional matrix array type transducer. A transducer of the present invention may also be used as a Sokolov type ultrasonic camera and as a transducer for an ultrasonic microscope. The operating frequency of this transducer varies depending on the thickness and structure of a piezoelectric film, however, by producing the same by taking into account these facts, it is possible to obtain a transducer operating a 1 MHz—100 MHz. When this transducer is operated at a low temperature, it is possible to emit and receive acoustic waves at a frequency in excess of 100 MHz.

It becomes possible for a transducer of the present invention to advance sensitivity (conversion efficiency) by about 3 dB or more (one pathway) (6 dB or more at two pathways) compared with a transducer using PVDF as a piezoelectric polymer material and the transducer of the present invention has a higher performance than the performance of any existing polymer piezoelectric ultrasonic transducer.

Brief Description of the Drawings

Figure 1 is a graph showing the variation of the values of the piezoelectric constant $d_{31}$ and the electromechanical coupling factor $K_t$ with the VDF—TrFE composition ratio of P(VDF—TrFE).

Figure 2 is a graph showing the relation between the poling temperature and the electromechanical coupling factor $K_t$.

Figure 3 is a graph showing the relation between the poling temperature and the piezoelectric constant $d_{31}$.

Figure 4 is a graph showing a DSC (differential scanning calorimetry) curve at a temperature raising speed of 10°C/min of a film treated under selected conditions.

Figure 5 is a graph showing the relation of the poling temperature and the preheat-treating temperature with the elastic constant (Young's modulus) $E'_{11}$.

Figure 6 is a graph showing the relation between the poling temperature and the electromechanical coupling factor $K_t$ of the preheat-treated film.

Figure 7 is a graph showing the relation between the poling temperature and the piezoelectric constant $d_{31}$ of the preheat-treated film.

Figure 8 is a graph showing a DSC (differential scanning calorimetry) curve at a temperature raising speed of 10°C/min of a film treated under selected conditions other than those of the case Figure 4.

Figure 9 is a graph showing a DSC (differential scanning calorimetry) curve at a temperature raising the speed of 10°C/min of a film treated under the further different selected conditions.

Figure 10 is a drawing showing the relation of the admittance and phase angle with the frequency of an ultrasonic transducer according to Example 10 of the present invention.

Figure 11 is a drawing showing the relation of the two kinds of conversion losses with the frequency in Example 11 of the present invention.

Figure 12 is an enlarged section showing the structure of the transducer in Example 12 of the present invention.

Figure 13 is a drawing showing the relation between the conversion loss and the frequency of the transducer shown in Figure 12.

Description of the Preferred Embodiments

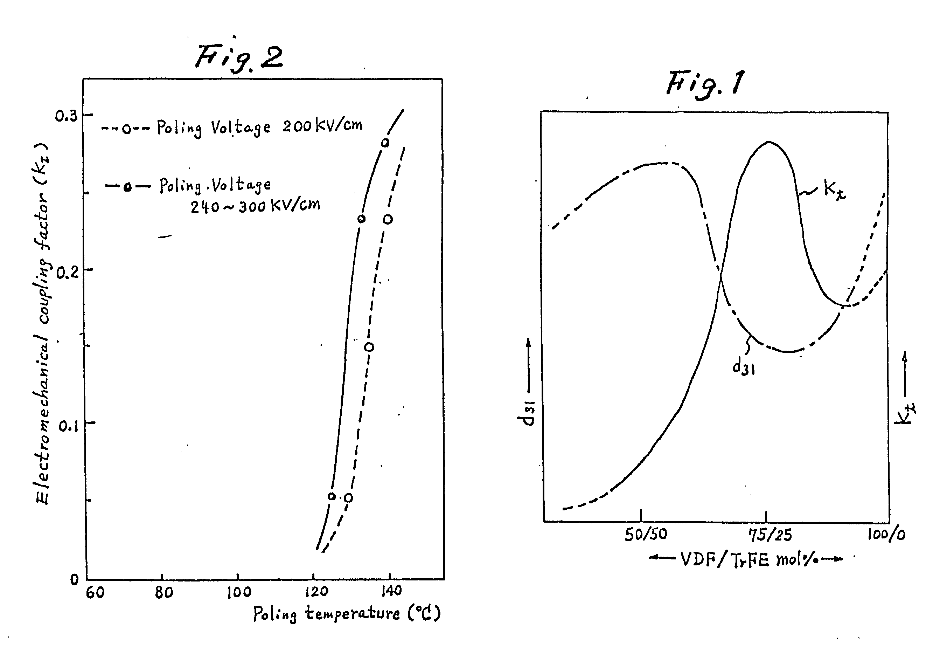

We, the present inventors investigated development of a piezoelectric polymer material suitable for uses wherein the effect of a piezoelectric material meeting the object is not adequate or the effect is entirely not obtained when the transverse piezoelectric properties are used, namely, uses wherein good thickness piezoelectric properties are required, in other words, uses utilizing the thickness piezoelectric properties per se of a piezoelectric polymer material, for example, uses wherein a piezoelectric polymer material is used as a receiving and/or a transmitting ultrasonic transducer which works under a thickness resonance mode, and during the process thereof, we carried out studies with reference to P(VDF—TrFE) as well. In this process, we found that even though a piezoelectric material has large transverse piezoelectric properties, said piezoelectric material does not always have large thickness piezoelectric properties at the same time, and with reference to P(VDF—TrFE), we found that the relation between the transverse piezoelectric properties and the thickness piezoelectric properties has roughly a slope shown in Fig. 1 with respect to the composition ratio of VDF—TrFE, thereby invented the present invention.

Namely, it was found that a piezoelectric body consisting of a shaped article of P(VDF—TrFE) shows an inclination that in the vicinity of the composition ratio of VDF—TrFE which is within the range of 55—45 mol %, the value of the constant $d_{31}$ showing the transverse piezoelectric properties beceomes the maximum, as the ratio of VDF increases, the value of the $d_{31}$ appreciably suddenly decreases, but when the composition ratio exceeds about 75—25 mol % and the ratio of VDF further increases, the value of the $d_{31}$ increases again. On the other hand, when the slope of the thickness piezoelectric properties is observed with respect to the composition ratio of VDF—TrFE from the value of the electromechanical coupling factor $K_t$ which is roughly in proportion to the size of the thickness piezoelectric properties and considered more proper to adjudicate the quality of the performance as an electromechanical transducer element utilizing the thickness piezoelectric properties which is one of the objects of the present invention than the piezoelectric constant $d_{33}$ showing the thickness piezoelectric properties, we found that at the composition of VDF—TrFE of 55—45 mol %, namely, the composition ratio at which the aforesaid transverse piezoelectric constant $d_{31}$ shows the maximum value, the value of the $K_t$ is so small as hardly be able to be utilized as an ultrasonic transducer, subsequently from a point where the ratio of VDF exceeds 65 mol %, the value of the $d_{31}$ shows an inclination of sudden decreases, whereas the $K_t$ shows a large value to an extent of being to be offered for practical use, at the same time, the $K_t$ value suddenly increases and at a point where the composition ratio of VDF—TrFE is in the vicinity of 75—25 mol %, the $K_t$ shows the maximum value, thereafter, as the ratio of VDF increases, the value of the $K_t$ decreases. Thereafter, when the ratio of VDF passes a point in the vicinity of 95 mol %, the value of the $K_t$ again shows an increasing slope.

From the variation of the composition ratio of VDF—TrFE of the transverse piezoelectric properties and the thickness piezoelectric properties mentioned above, it turns out that, in order to obtain a piezoelectric material good in thickness piezoelectric properties, selection of the composition ratio of VDF—TrFE different from that of a piezoelectric material good in transverse piezoelectric properties is at least necessary. The reason why it is stated herein as at least necessary is, when the composition ratio of VDF—TrFE is merely selected in accordance with an inclination shown in Fig. 1 and when that shaped article is merely subjected to a poling treatment, it is not that said shaped article becomes a piezoelectric material having a sufficient value of the electromechanical coupling factor $K_t$ capable of being immediately offered for practical use, but it is necessary that a piezoelectric body having a sufficient value of the $K_t$ capable of being offered for practical use should be poled after being imparted with a heat-treatment effect under specified conditions or should be poled while a heat-treatment effect is being imparted thereto.

Hereinbelow, the present invention will be further explained using examples and comparative examples.

Comparative Examples 1—4

P(VDF—TrFE) having the composition ratio of VDF—TrFE of 37—63 mol % was hot pressed at 250°C. The obtained film was rolled at 70°C to be drawn to about 4 times to obtain a drawn film having a thickness of about 40 $\mu$m. On the two surfaces of this drawn film was vacuum evaporated Al to form electrodes and the film was subjected to a poling treatment under conditions shown in Table 1 or once heat-treated in advance and then subjected to the poling treatment under conditions shown in Table 1. The vale of the piezoelectric constant $d_{31}$ showing the transverse piezoelectric properties and the values of the electromechanical coupling factor $K_t$ showing the thickness piezoelectric properties of the obtained piezoelectric bodies are shown in Table 1.

For information, the preheat-treatment was carried out in air atmosphere for 1 hour. The melting temperature $T_m$ of the drawn film used in these comparative examples was about 167°C and crystal phase transition temperature $T_m'$ of said film was about 50°C.

Because these comparative examples used the shaped article of P(VDF—TrFE) having the composition ratio of VDF—TrFE outside the range defined by the present invention, it is shown that even though the preheat-treating temperature or the poling temperature was in excess of $[T_m' - 5]°C$, piezoelectric bodies each having a large electromechanical coupling factor $K_t$ could not be produced.

TABLE 1

| | Preheat-treatment Temp (°C) | 'Poling conditions | | | Piezoelectric characteristics | |
|---|---|---|---|---|---|---|
| | | Temp (°C) | Voltage (KV/cm) | Time (hr) | $d_{31}$ $(10^{-12}$ C /N) | $K_t$ |
| Comp Example 1 | None | 50 | 300 | 1 | 13.4 | below 0.01 |
| Comp Example 2 | None | 80 | 300 | 1 | 24.2 | below 0.01 |
| Comp Example 3 | None | 100 | 300 | 1 | 21.9 | below 0.01 |
| Comp Example 4 | 140 | 100 | 300 | 1 | 22.3 | below 0.01 |

# 0 037 877

Comparative Examples 5—7

P(VDF—TrFE) having the composition ratio of VDF—TrFE of 49—51 mol % was hot pressed at 250°C and the obtained film was rolled at 80°C to be drawn to about 2 times to obtain a drawn film having a thickness of about 50 $\mu$m. On the two surfaces of this drawn film was vacuum evaporated Al to form electrodes and the film was subjected to poling treatment. The values of the piezoelectric constant $d_{31}$ and the values of the electromechanical coupling factor $K_t$ of the obtained piezoelectric bodies are shown in Table 2.

For information, the melting point temperature $T_m$ of the drawn film used in these comparative examples was about 160°C and crystal phase transition temperatures $T_m'$ of said film was about 60°C.

Because these comparative examples used the shaped article of P(VDF—TrFE) whose composition ratio of VDF—TrFE was outside the range defined by the present invention, even though the poling temperature were more than $[T_m' — 5]°C$, the increase of the electromechanical coupling factor $K_t$ was not seen, said $K_t$ was 0.01 or less and did not exceed 0.05.

9

TABLE 2

| | Preheat-treatment Temp (°C) | Poling conditions | | | Piezoelectric characteristics | |
|---|---|---|---|---|---|---|
| | | Temp (°C) | Voltage (KV/cm) | Time (hr) | $d_{31}$ ($10^{-12}$C/N) | $K_t$ |
| Comp Example 5 | None | 50 | 300 | 1 | 8.85 | below 0.01 |
| Comp Example 6 | None | 80 | 300 | 1 | 17.0 | below 0.01 |
| Comp Example 7 | None | 100 | 300 | 1 | 10.9 | below 0.01 |

0 037 877

Comparative Examples 8—11

A film obtained by hot pressing P(VDF—TrFE) having the composition ratio of VDF—TrFE of 55—45 mol % at 250°C was uniaxially drawn to about 3.4 times at 40°C to obtain a drawn film having a thickness of about 50 $\mu$m in Comparative Examples 8—10 and rolled at 40°C to obtain a drawn film having a thickness of about 50 $\mu$m in Comparative Example 11. On the two surfaces of each of these drawn films was vacuum evaporated Al to form electrodes and the respective films were subjected to poling treatments under conditions shown in Table 3 or subjected to a heat-treatment in advance and thereafter subjected to a poling treatment. The values of the electromechanical coupling factor $K_t$ of the obtained piezoelectric bodies are shown in Table 3.

For information, the preheat-treatment was carried out in air atmosphere for 1 hour. The melting point temperature $T_m$ of the drawn film used in Comparative Examples 8—10 was about 156°C and the crystal phase transition temperature $T_m'$ of said drawn film was 81°C. The melting point temperature $T_m$ of the drawn film used in Comparative Example 11 was about 155°C and the crystal phase transition temperature $T_m'$ of said film was about 82°C.

TABLE 3

| | Preheat-treatment Temp (°C) | Poling conditions | | | Piezoelectric characteristics | |
|---|---|---|---|---|---|---|
| | | Temp (°C) | Voltage (KV/cm) | Time (hr) | $d_{31}(10^{-12}C/N)$ | $K_t$ |
| Comp Example 8 | None | 50 | 300 | 1 | 14.5 | below 0.01 |
| Comp Example 9 | None | 80 | 300 | 1 | 17.6 | below 0.01 |
| Comp Example 10 | None | 100 | 300 | 1 | 28.4 | 0.02 |
| Comp Example 11 | 140 | 80 | 200 | 1 | 25.5 | 0.03 |

0 037 877

Because these comparative examples used the shaped article of P(VDF—TrFE) having the composition ratio of VDF—TrFE which was outside the range defined by the present invention, even though the poling temperatures or preheat-treating temperature was more than $[T_m' — 5]°C$, the increase of the electromechanical coupling factor $K_t$ was not seen, said $K_t$ was 0.02 or 0.03, or still small and insufficient for being offered for practical use.

## Example 1

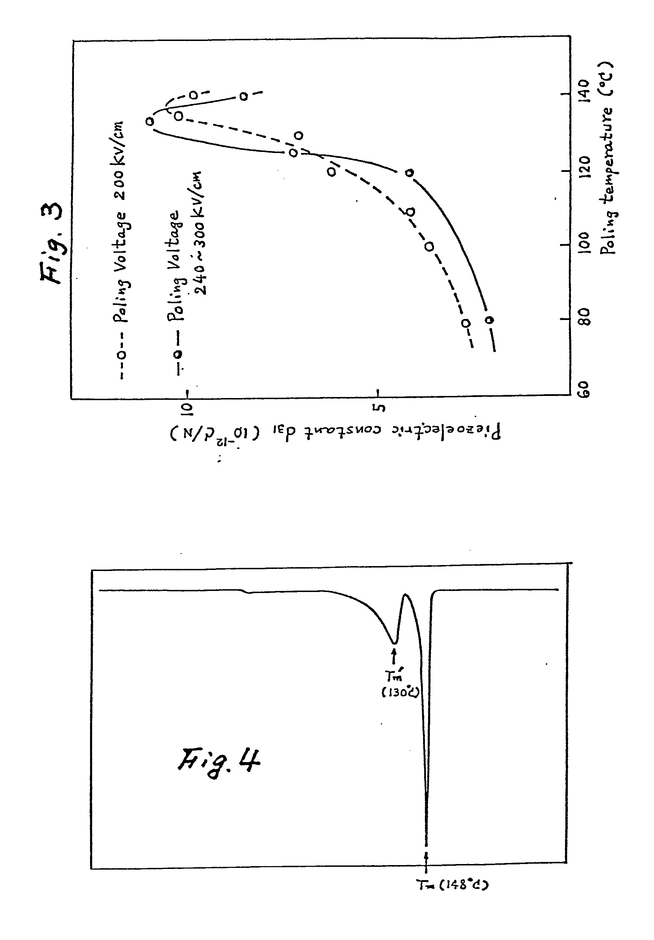

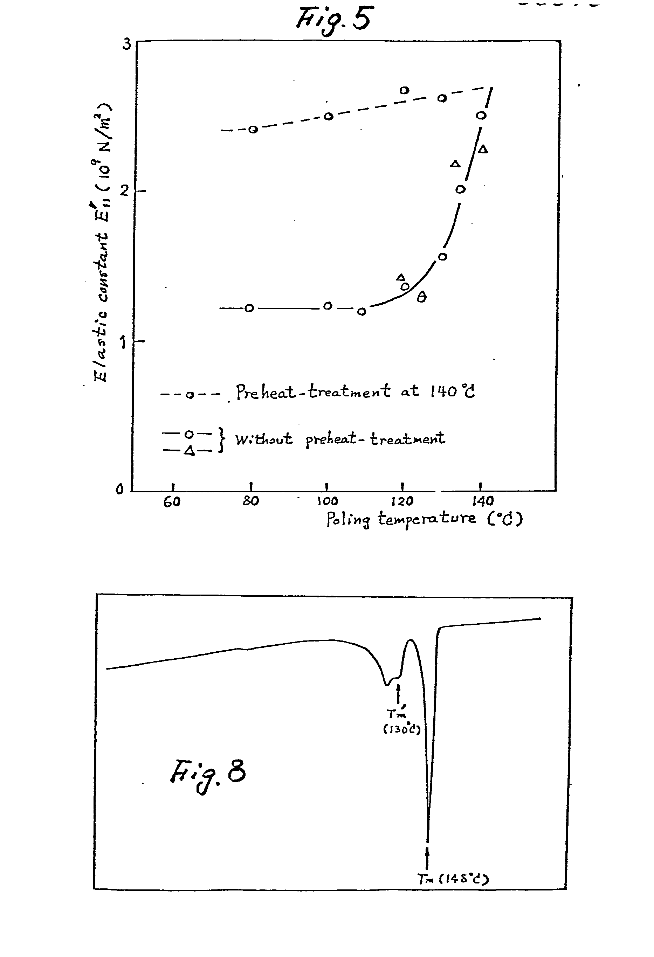

P(VDF—TrFE) having the composition ratio of VDF—TrFE of 75—25 mol % was extruded at 210°C, the obtained film was rolled at room temperature and drawn to about 3 times to obtain a drawn film having a thickness of about 35 $\mu$m. On the two surfaces of this film was vacuum evaporated Al to form electrodes and said film was subjected to a poling treatment by the direct poling method at a poling temperature of 80—140°C and a poling voltage of 200—300 KV/cm for 1 hour to produce piezoelectric bodies. The values of the electromechanical coupling factor $K_t$ of the piezoelectric bodies as a result are shown in Fig. 2 and the values of the piezoelectric constant $d_{31}$ of said bodies are shown in Fig. 3. The melting temperature $T_m$ of the drawn film used in this example was about 148°C and the crystal phase transition temperature $T_m'$ of said film was about 130°C. The DSC (differential scanning calorimetry) curve of this film is shown in Fig. 4.

Fig. 2 shows that by the use of the shaped article of P(VDF—TrFE) having the composition ratio of VDF—TrFE within the range defined by the present invention and by carrying out the poling treatment at a poling temperature selected from the range of the poling temperature defined by the present invention, it is possible to produce a piezoelectric body having a good value of the electromechanical coupling factor $K_t$. Moreover, Fig. 2 shows that the poling temperature is less than $[T_m' — 5]°C$, the electromechanical coupling factor $K_t$ is too small to be decided, however, when the poling temperature becomes at least $[T_m' — 5]°C$, the electromechanical coupling factor $K_t$ suddenly increases and when said temperature becomes at least $T_m'$, said factor becomes at least 0.1 and when the poling temperature becomes about 140°C, a piezoelectric body, the value of whose electromechanical coupling factor $K_t$ reaches about 0.3 is obtained. The elastic constant $E_{11}'$ (Young's modulus measured at 110 Hz along the X direction) of a piezoelectric body obtained by subjecting said drawn film to a poling treatment at a poling temperature of 80—140°C and a poling voltage of about 210 KV/cm for 1 hour by the direct poling method, is shown as a function of poling temperature by a solid line in Fig. 5. This Fig. 5 shows that when the poling temperature becomes at least $[T_m' — 5]°C$, the value of the elastic constant $E_{11}'$ suddenly increases. It was also shown that the sound velocity and elastic constant $C_{33}^D$ increase when the poling temperature becomes at least $[T_m' — 5]°C$.

## Example 2

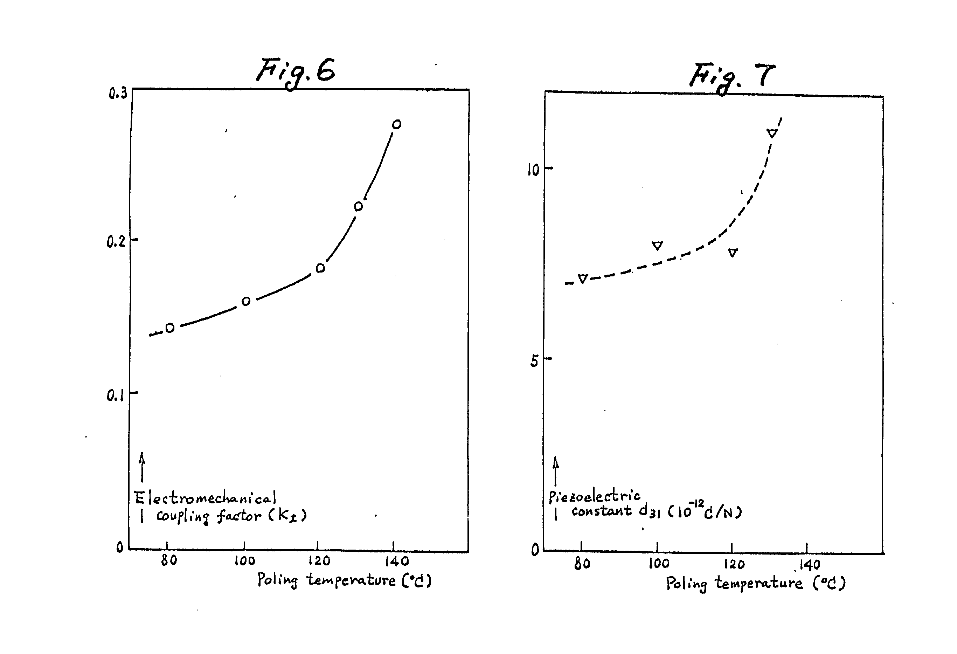

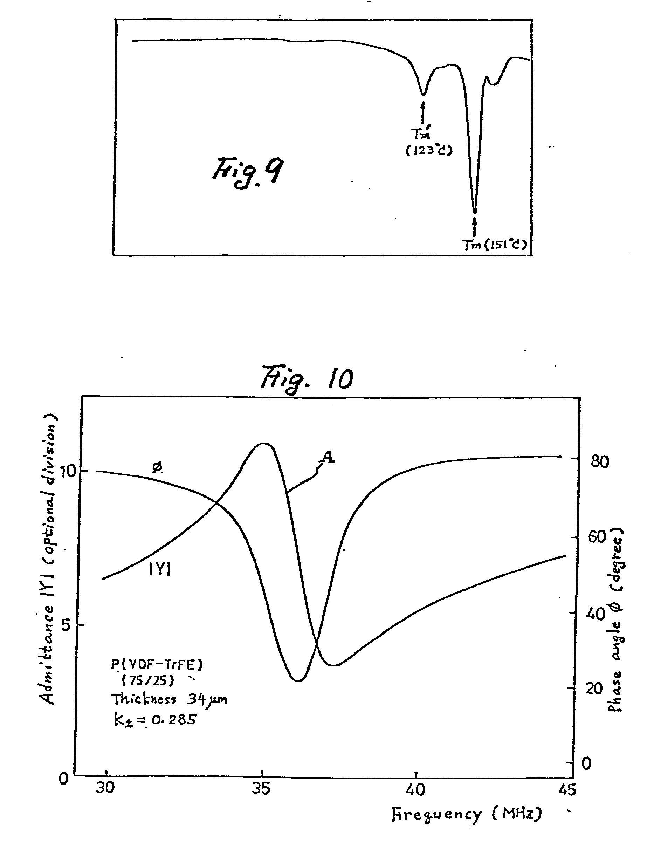

On the two surfaces of the same drawn film as used in Example 1 was vacuum evaporated Al, said film was heat-treated by the preheat-treating method and thereafter poled subsequently to produce a piezoelectric body. The heat-treating were performed at 140°C in air atmosphere for 1 hour and after the treatment, the film was taken out to an atmosphere at room temperature and allowed to stand therein. The so obtained heat-treated film was subjected to a poling temperature of 80—140°C and at a poling voltage of 210 KV/cm for 1 hour. The values of the electromechanical coupling factor $K_t$ are shown in Fig. 6 and the value of the piezoelectric constant $d_{31}$ of said piezoelectric bodies are shown in Fig. 7.

Fig. 6 shows that when the piezoelectric bodies are heat-treated at a temperature of at least $[T_m' — 5]°C$ in advance, even though low temperatures are selected in the poling treatment, it is possible to produce piezoelectric bodies having the desired value of the electromechanical coupling factor $K_t$. This point is more clearly understood by comparing Fig. 6 with Fig. 2, which will become a proof the advantage of the aforesaid preheat-treating method. On the other hand, the value of the elastic constant $E_{11}'$ of the so obtained piezoelectric bodies are shown in dotted lines in said Fig. 5. This Fig. 5 shows that according to the preheat-treating method, even though the poling treatment is carried out at low poling temperature, it is possible to produce piezoelectric bodies having large values of the elastic constant $E_{11}'$. The piezoelectric bodies having large values of this elastic constant $E_{11}'$ mean that when they are used as ultrasonic transducer utilizing the thickness piezoelectric properties of the piezoelectric bodies, they are advantageously used as good vibrators because their mechanical losses are small.

## Examples 3—7

The values of the electromechanical coupling factor $K_t$ of the piezoelectric bodies obtained by subjecting the heat-treated film obtained in said Example 2 to poling treatments at poling temperatures and poling voltages are shown in Table 4.

This Table 4 shows that according to the preheat-treating method, even when the poling temperature is 60°C or even room temperature, it is possible to produce piezoelectric bodies having practically offerable of the electromechanical coupling factor $K_t$.

TABLE 4

| | Poling conditions | | Piezoelectric characteristics $K_t$ |
| --- | --- | --- | --- |
| | Temp (°C) | Voltage (KV/cm) | |
| Example 3 | 60 | 171 | 0.126 |
| Example 4 | 60 | 333 | 0.193 |
| Example 5 | 60 | 364 | 0.258 |
| Example 6 | 60 | 474 | 0.301 |
| Example 7 | room temp (25) | 528 | 0.281 |

Example 8

A film obtained by heat pressing at 250°C having the composition ratio of VDF—TrFE of 75—25 mol % was rolled and drawn to about 2.5 times to obtain a drawn film having a thickness of about 50 $\mu$m. On the two surfaces of this drawn film was vacuum evaporated Al to form electrodes and the film was subjected to a poling treatment under conditions shown in Table 5. The value of the piezoelectric constant $d_{31}$ and the value of the electromechanical coupling factor $K_t$ of the obtained piezoelectric body are shown in Table 5.

For information, the melting point temperature $T_m$ of the drawn film used in this example was about 148°C and the crystal phase transition temperature $T_m'$ of said film was about 130°C. The DSC curve of this film is shown in Fig. 8.

TABLE 5

| | Preheat-treatment Temp (°C) | Poling conditions | | | Piezoelectric characteristics | |
|---|---|---|---|---|---|---|
| | | Temp (°C) | Voltage (KV/cm) | Time (hr) | $d_{31}(10^{-12}C/N)$ | Kt |
| Example 8 | None | 130 | 200 | 1 | 9.2 | 0.104 |

### Comparative Example 12 and Example 9

A film obtained by hot pressing at 250°C having the composition ratio of VDF—TrFE 82—18 mol % was not drawn, but on the two surfaces of said film was vacuum evaporated Al to form electrodes and the film was subjected to poling treatment under conditions shown in Table 6. The values of the piezoelectric constant $d_{31}$ and values of the electromechanical coupling factor $K_t$ of the obtained piezoelectric bodies are shown in Table 6.

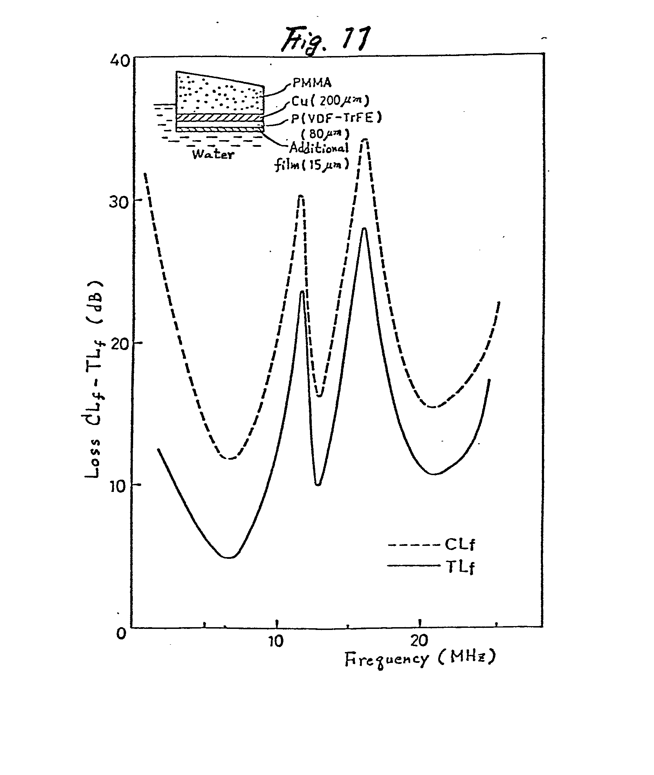

For information, the melting point temperature $T_m$ of the non-drawn film used in this comparative example and example was about 151°C and the crystal phase transition temperature $T_m'$ of said non-drawn film was about 123°C. The DSC curve of these temperature is shown in Fig. 9.

This comparative example and example show that in the case of P(VDF—TrFE) having the composition ratio of VDF—TrFE of 82—18 mol %, namely, within the range defined by the present invention, when the poling temperature imparting the heat-treatment effect is less than $[T_m' — 5]$°C, namely, outside the range defined by the present invention, the value of the electromechanical coupling factor $K_t$ is 0.01, which is small, however, by selecting the poling temperature of at least $[T_m' — 5]$°C, further, $T_m'$ per se (in this case, it is about 123°C as mentioned above), it is possible to produce a piezoelectric body having the value of the electromechanical coupling factor $K_t$ of 0.09, or an increased value.

TABLE 6

| | Preheat-treatment Temp (°C) | Poling conditions | | | Piezoelectric characteristics | |
|---|---|---|---|---|---|---|
| | | Temp (°C) | Voltage (KV/cm) | Time (hr) | $d_{31}$ $(10^{-12}C/N)$ | Kt |
| Comp Example 12 | None | 80 | 300 | 1 | 0.61 | 0.010 |
| Example 9 | None | 140 | 300 | 1 | 6.0 | 0.090 |

0 037 877

## Example 10

On the two surfaces of a 34 $\mu$m thick P(VDF—TrFE) film having a VDF—TrFE composition ratio of 75—25 mol % drawn by rolls at 70°C was vacuum evaporated Al to form electrodes and said film was heat-treated at 140°C for 1 hour. Subsequently, an electric field of 1300 V voltage was applied to said electrodes at 130°C, said film was held for 1 hour and thereafter cooled per se to room temperature to effect a poling treatment.

From this film, a 1 cm² disk was cut out and based on the method descrbed in H. Ohigashi, J. Appl. Phys., *47* 949 (1976), from the electric behavior in the vicinity of a resonance point of piezoelectric thickness free vibrator, the electric-acoustic properties of this P(VDF—TrFE) piezoelectric body were measured. Fig. 10 is a graph showing a result obtained by measuring at room temperature the relation of the absolute value of the electric admittance in an acoustically non-load state of said thickness piezoelectric vibrator element and its phase angle, respectively with the frequency. The resonance peak at |Y| — f curve (curve A) in Fig. 10, the difference from a valley in the vicinity of an anti-resonance point and the varied amount of the phase angle are larger than those of any hitherto known high polymer piezoelectric vibrator.

Table 7 shows various constants obtained by comparing the admittance expected from the admit-tance of the vibrator.

$$Y = j\omega C_0(1-j\phi) + \frac{\omega C_0(1-j\phi)^2 K_t^2}{(1-j\frac{\psi}{2})(\frac{\omega t}{2V_3}) \coth\left[j(1-\frac{1}{2}j\psi)\frac{\omega t}{2V_3}\right] + j(1-j\phi)K_t^2}$$

wherein

$$C_0 = \frac{\epsilon^S A}{t} \qquad V_3^D = \sqrt{\frac{C_{33}^D}{\rho}} \qquad K_t^2 = \frac{e_{33}^2}{C_{33}^D \epsilon_3^S}$$

$$\psi = Q_m^{-1} \qquad \phi = Q_e^{-1}$$

A and t are the area and thickness of the vibrator and
$Q_m$, $Q_e$; Mechanical Q and electric Q
$\psi$, $\varphi$; dynamic loss tangent, electric loss tangent
Other constants are in accordance with the customary usage.

The constants with reference to PVDF similarly sought are also tabulated in Table 7. Again, comparison, of piezoelectric constant $d_{31}$ concerning expansion and contraction in the drawing direction is shown also.

As is shown in Table 7, P(VDF—TrFE) has a $K_t$ value larger tha that of PVDF, having dielectric loss and mechanical loss smaller than those of PVDF. This fact means that the efficiency at which electric energy (mechanical energy) put into the vibrator is converted to mechanical energy (electric energy) is good and the possibility that electric energy (mechanical energy) is converted to heat energy is small, showing that the vibrator is good.

The element obtained in this example was adhered to one surface of a PMMA (polymethyl methacrylate) block (A) and a 6 mm PMMA plate (B) was adhered to the other surface to prepare a waterproof ultrasonic transducer. This transducer was immersed in water and at a position 3 mm forward of the transducer, a 1 mm thick brass plate was placed in parallel to the PMMA plate (B). This transducer was excited with a short pulse to generate a ultrasonic pulse, the reflective signal of which was received by the same transducer. The thickness of the brass plate could be measured by the signals of multi-reflection from the front and rear surface of the brass plate. By this example, it was confirmed that this transducer generated ultrasonic wave having a practically sufficient intensity.

TABLE 7

|  | P(VDF-TrFE) | PVDF |
|---|---|---|
| Electromechanical coupling factor $K_t$ | 0.285 | 0.20 |
| Piezoelectric constant $e_{33}(C/m^2)$ | −0.23 | −0.165 |
| Sonic Speed $V_3$ m/s) | 2460 | 2260 |
| Density $(10^3 kg/m^3)$ | 1.85 | 1.78 |
| Elastic constant $C_{33}^D(10^9 N/m^2)$ | 11.2 | 9.47 |
| Dynamic loss tangent $\psi$ | 0.05 | 0.1 |
| Dielectric constant $\varepsilon_3^S/0$ | 6.5 | 6.2 (5.6) |
| Dielectric loss tangent $\varphi$ | 0.20 | 0.25 |
| Piezoelectric constant $d_{31}(10^{-12}C/N)$ | 14 | 27.0 |

⧣ Note: In Table 7, the value of the piezoelectric constant $d_{31}$ was measured at 110 Hz (non-resonance).

⧣ Note: In Table 7, the piezoelectric PVDF film was obtained by subjecting 4-time drawn PVDF film to poling treatment at poling temperature of 120°C for poling time of 1 hour at poling voltage of 800 KV/cm.

Example 11

As shown in Fig. 11, the frequency characteristics of two kinds of conversion losses $CL_f$ and $TL_f$ for underwater driving of an ultrasonic transducer obtained by successively laminating a PMMA base plate, a copper plate (200 $\mu$m), P(VDF—TrFE) (area 1.32 cm$^2$, thickness 80 $\mu$m) and a high polymer additional film (aromatic polyamide, 15 $\mu$m) were sought using a Mason's circuit. Said $CL_f$ was defined by $CL_f = -10 \log (P_{Af}/P_0)$ wherein $P_0$ was the maximum electric power utilizable from the power source of 50 $\Omega$ and $P_{Af}$ was an acoustic power output into water from the transducer. Said $TL_f$ was defined by $TL_f = -10 (\log P_{Af}/P_T)$ wherein $P_T$ was an effective electric power put into the transucer from the power source. The effective area of the aforesaid transducer was 1 cm$^2$ and the copper plate concurrently acted as a back surface electrode and an acoustic reflective plate. On the surfaces of the P(VDF—TrFE) film, confronting electrodes were provided. As the physical property constants of P(VDF—TrFE), the values in Table 7 were used. The results are shown in Fig. 11. At the most efficiently operating resonance frequency (6.5 MHz), $CL_f$ and $TL_f$ were about 12 dB and 5 dB, respectively and improvements by 3—4 dB were seen from a transducer using the same constitution of PVDF ($K_t = 0.2$). This makes increase of the sensitivity on two pathways by 6 dB in ultrasonic diagnosis used by a pulse reflection method, meaning that this is a transducer having very good S/N (signal to noise ratio).

From a laminated film (thickness about 80 $\mu$m) obtained by overlapping 2 films (each having a thickness of about 40 $\mu$m) obtained in the same manner as in Example 10 with their polarization directions being made in parallel to each other, a transducer having a structure shown in Fig. 11 was produced and the frequency characteristics of its losses were measured by operation in water. The results shown in Fig. 11 are in good agreement with ones predicted theoretically.

Example 12

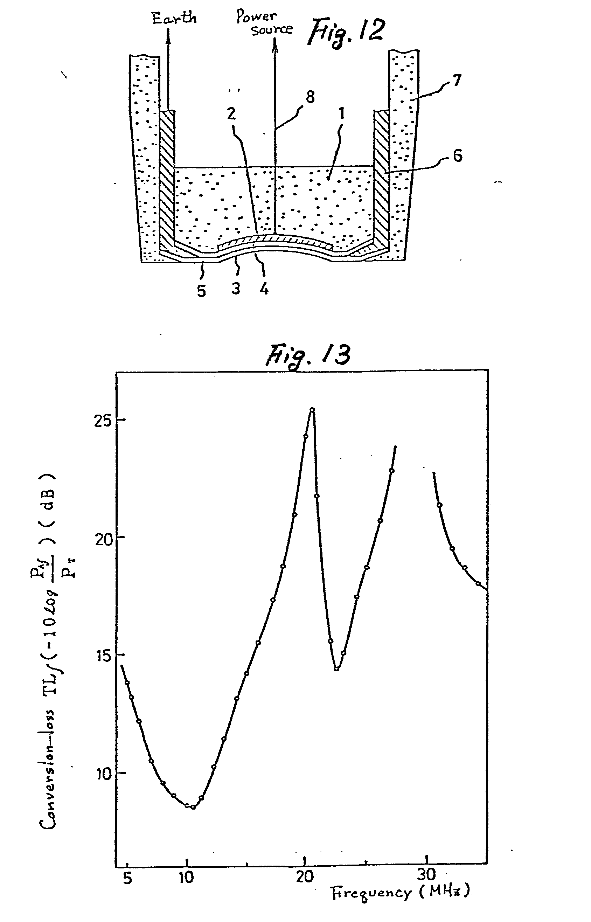

As shown in Fig. 12, onto a PMMA base plate 1, a 100 $\mu$m thick copper plate (radius 13 mm) shaped into a concave state by a mold having a radius of curvature of 70 mm was adhered, to which was adhered a 43 $\mu$m thick P(VDF—TrFE) piezoelectric film 4 (diameter 19 mm) having an Al vacuum evaporated electrode 3 on one surface, to the electrode 3 on the piezoelectric film was electrically connected a metal case for grounding 6, thereafter, onto the piezoelectric film was adhered a polyester film 5 (thickness 15 $\mu$m) for the purpose of protecting the surface and reducing the operating frequency and all of them was accomodated inside a plastic case 7. By applying a burst-like high frequency electric power to a space between a leading wire 8 connected to the copper plate electrode 2 and the grounded case 6, the frequency characteristics of the conversion loss $TL_f$ of this transducer in the case of the underwater operation were measured by a pulse reflection method. The results are shown in Fig. 13. The piezoelectric body made of P(VDF—TrFE) used in this example had a molar ratio of its components of 75/25, being obtained by vacuum evaporating Al on the two surfaces of a film drawn by rolls at 70°C and thereafter subjecting the film to a poling treatment at a poling temperature of 133°C, a

19

poling voltage of 250 KV/cm for a poling time of 1 hour. As a result of analyzing the frequency characteristics of the impedance of the free vibrator, the value of $K_t$ was found to be 0.24.

As shown in Fig. 13, the $TL_f$ of this tranducer at the center frequency of 10 MHz was 8.5 dB. Because the minimum $TL_f$ experimentally obtained by a transducer similarly constituted using a PVDF piezoelectric film ($K_t = 0.2$) and poled under good conditions was 11 dB, it is seen that by the use of P(VDF—TrFE) ($K_t = 0.24$), an improvement by about 2.5 dB was made.

For efficiently driving this tranducer by a 50 $\Omega$ power source, a matching circuit consisting of a matching coil and an impedance conversion transformer was inserted between the power source and a piezoelectric element. As a result, it was possible remove the reflection between the transducer and power source. The loss ($-10 \log P_{Af}/P_0$) of the so matched transducer was 8.5 dB at 10 MHz.

Typical Experiments data will be shown in Tables 8—12. Some experiments shown in Tables 8—12 have been described more precisely in the above Examples and Comparative Examples. Columns I—XII in Table 8—12 means as follows:

Column I: Experiment number.

Column II: Content of VDF (mol%) in copolymer of P(VDF—TrFE). 72/79 means that two kinds of the copolymers having respectively 72 and 79 mol % VDF are blended with same volume.

Column III: Forming conditions of shaped article of copolymer of P(VDF—TrFE).

Notes in Column III:

(1) HP(250) means that the shaped article is formed by a hot pressing at a temperature of 250°C.

(2) RD(50) means that the shaped article formed by the hot pressing is drawn by between a pair of nip rolls at a temperature of 50°C.

(3) ME means that the shaped article is formed by melt extruding.

(4) SC means that the shaped article is formed by solvent casting.

(5) VD means that the shaped article formed by the solvent casting is dried in vacuum atmosphere.

(6) IWC means that the shaped article formed by the hot pressing is cooled with iced water.

(7) AC means that the freshly shaped article formed by the hot pressing is cooled in room air atmosphere.

(8) WC(40) means that the freshly shaped article formed by the hot pressing is cooled with water having a temperature of 40°C.

(9) DWC(20) means that the freshly shaped article formed by the melt extruding is cooled with shower of water having a temperature of 20°C on a drafting drum of the shaped article.

(10) DAC means that the freshly shaped article formed by the melt extruding is cooled in room air on a drafting drum of the shaped article.

(11) AC(140) means that the freshly shaped article formed by the hot pressing is heat-treated at 140°C for 1 hour by maintaining the shaped article in hot air atmosphere in the course of cooling down the shaped article to room temperature.

Column IV: Conditions of drawing the shaped article. Semi-column A shows drawing temperature (°C) and B shows drawing ratio.

Column V: Thickness ($\mu$m) of the shaped article being subjected to preheat-treating or direct poling.

Column VI: Semi-column A shows a temperature (°C) of melting point ($T_m$) and B shows crystal phase transition temperature (°C) ($T_m'$) of the shaped article being subjected to preheat-treating or direct poling. The numeral enclosed with parentheses means the shoulder showing $T_m'$ is not so clear.

Column VII: Preheating conditions. Semi-column A shows a temperature (°C) of preheating and B shows a time (hour) for preheating.

Column VIII: Poling conditions. Semi-column A shows a temperature (°C) of poling and B shows a time (hour) for poling.

Column IX: Semi-column A shows a temperature (°C) of melting point ($T_m$) and B shows crystal phase transition temperature (°C) ($T_m'$) of the shaped article after preheat-treating or poling.

Column X: Semi-column A shows poling voltage (KV/cm) and B shows thickness extensional electromechanical coupling factor ($K_t$).

Column XI: Semi-column A shows poling voltage (KV/cm) and B shows transverse piezoelectric property ($d_{31}$) ($10^{-12}$C/N).

Column XII: "NO" means that the experimental sample is out of the scope of the present invention and "YES" means that the experimental sample is in the scope of the present invention

TABLE 8

| I | | II | III | IV | | V | VI | | VII | | VIII | | IX | | X | | XI | | XII |
|---|---|----|-----|---|---|---|----|----|-----|---|------|---|----|---|---|---|----|---|-----|
| | | | | A | B | | A | B | A | B | A | B | A | B | A | B | A | B | |
| PD | 90 | 37 | HP(250) · RD(70) | 70 | 4 | 40 | 167 | 50 | none | — | 50 | 1 | — | — | 300 | <0.01 | 300 | 13.4 | NO |
| PD | 67 | „ | „ | „ | „ | „ | „ | „ | „ | „ | 80 | „ | — | — | „ | „ | „ | 24.2 | „ |
| PD | 69 | „ | „ | „ | „ | „ | „ | „ | „ | „ | 100 | „ | — | — | „ | „ | „ | 21.9 | „ |
| PD | 70 | „ | „ | „ | „ | „ | „ | „ | 140 | 1 | „ | „ | — | — | „ | „ | „ | 22.3 | „ |
| PD | 91 | 49 | HP(250) · RD(80) | 80 | 2 | 50 | 160 | 60 | none | — | 50 | 1 | — | — | 300 | <0.01 | 300 | 8.8 | NO |
| PD | 72 | „ | „ | „ | „ | „ | „ | „ | „ | „ | 80 | „ | — | — | „ | „ | „ | 17.0 | „ |
| PD | 73 | „ | „ | „ | „ | „ | „ | „ | „ | „ | 100 | „ | — | — | „ | „ | „ | 10.9 | „ |
| PD | 42 | 55 | HP(250) · D(40) | 40 | 3.4 | 50 | 156 | 81 | none | — | 50 | 1 | — | — | 300 | <0.01 | 300 | 14.5 | NO |
| PD | 39 | „ | „ | „ | „ | „ | „ | „ | „ | „ | 80 | „ | — | — | „ | „ | „ | 17.6 | „ |
| PD | 40 | „ | „ | „ | „ | „ | „ | „ | „ | „ | 100 | „ | — | — | „ | 0.02 | „ | 28.4 | „ |
| PD | 57 | „ | ME · RD(85) | 85 | 2 | „ | 155 | 82 | 140 | 1 | 80 | „ | — | — | 200 | 0.03 | 200 | 25.5 | „ |
| CD | 142 | 66 | SC · VD | 80 | 6.3 | 25 | — | — | 140 | 1 | 80 | 1 | — | — | 400 | 0.188 | 370 | 9.6 | YES |
| PUD283 | | „ | HP(270) · IWC | none | — | 100 | 150 | 95 | 141 | „ | 100 | „ | — | — | 329 | 0.181 | — | — | „ |
| PUD281 | | „ | HP(280) · AC | „ | „ | 103 | „ | „ | 140 | „ | „ | „ | — | — | 340 | 0.174 | — | — | „ |
| CUD153 | | „ | SC · VD | „ | „ | 46 | — | — | „ | „ | 80 | „ | — | — | 362 | 0.06 | — | — | „ |

0 037 877

TABLE 9

| I | II | III | IV A | IV B | V | VI A | VI B | VII A | VII B | VIII A | VIII B | IX A | IX B | X A | X B | XI A | XI B | XII |
|---|---|---|---|---|---|---|---|---|---|---|---|---|---|---|---|---|---|---|
| PD 191 | 72 | HP(290)·IWC | 80 | 7 | 35 | 148 | (123) | 140 | 1 | 100 | 1 | 149 | 117 | 314 | 0.201 | 314 | 12.6 | YES |
| PD 192 | " | HP(240)·IWC | " | 5.8 | 53 | " | " | — | — | 140 | " | " | " | 255 | 0.204 | 228. | 14.1 | " |
| CU; 197 | " | SC·VD | none | — | 69 | 147 | (105) | 140 | 1 | 100 | " | 147 | " | 348 | 0.170 | 234 | 5.7 | " |
| CD 199 | " | " | 70 | 5.7 | 43 | 148 | (109) | " | " | " | " | 149 | 118 | 349 | 0.184 | 300 | 11.7 | " |
| CD 203 | " | " | 83 | 5.6 | 47 | " | 109 | " | " | 80 | " | — | — | 426 | 0.289 | 426 | " | " |
| PUD233 | " | HP(290)·IWC | none | — | 80 | " | 122 | " | " | 100 | " | — | — | 423 | 0.259 | — | — | " |
| PUD278 | " | HP(270)·AC | " | " | 87 | 151 | 115 | " | " | 130 | " | — | — | 230 | 0.—84 | — | — | " |
| PUD280 | " | " | " | " | 84 | " | " | " | " | 100 | " | — | — | 536 | 0.204 | — | — | " |
| PD 221 | 74 | HP(270)·IWC | 80 | 5.6 | 45 | 148 | 128 | 140 | 1 | 100 | .5 | — | — | 333 | 0.258 | — | — | " |
| PD 236 | " | " | " | " | " | — | — | " | " | 60 | 1 | — | — | 462 | 0.290 | 474 | 7.3 | " |
| PD 222 | " | HP(270)·WC(40) | " | 5.0 | " | — | — | " | " | 100 | " | — | — | 321 | 0.238 | — | — | " |
| PD 237 | " | " | " | " | — | | — | " | " | 60 | " | — | — | 432 | 0.269 | 373 | 9.5 | " |
| PD 226 | " | HP(270)·WC(60) | " | 4.8 | 51 | — | — | " | 2 | 100 | " | — | — | 333 | 0.224 | — | — | " |
| PD 227 | " | " | " | " | 58 | — | — | " | " | 60 | " | — | — | 414 | 0.240 | 436 | 10.5 | " |
| PD 230 | " | " | " | 4.6 | 60 | — | — | " | 1 | 100 | " | — | — | 310 | 0.266 | 295 | 13.9 | " |
| PD 245 | " | HP(270)·WC(78) | " | 5.0 | 65 | — | — | " | " | " | " | — | — | 396 | 0.245 | — | — | " |
| PUD292 | " | HP(270)·AC | none | — | 80 | 150 | 122 | 141 | " | " | .5 | — | — | 563 | 0.219 | — | — | " |
| PUD229 | " | HP(270)·IWC | " | " | 79 | — | — | 140 | " | " | 1 | — | — | 380 | 0.234 | 306 | 8.3 | " |
| PUD250 | " | HP(270)·WC(40) | " | " | 83 | — | — | " | " | " | " | — | — | 422 | 0.291 | — | — | " |

0 037 877

TABLE 10

| | I | II | III | IV | | V | VI | | VII | | VIII | | IX | | X | | XI | | XII |
|---|---|---|---|---|---|---|---|---|---|---|---|---|---|---|---|---|---|---|---|
| | | | | A | B | | A | B | A | B | A | B | A | B | A | B | A | B | |
| | PUD251 | 74 | HP(270)·WC(60) | none | — | 78 | — | — | 140 | 1 | 100 | 1 | — | — | 437 | 0.276 | — | — | YES |
| | CD 238 | „ | SC·VD | 83 | 4.9 | 82 | — | — | „ | „ | 60 | „ | — | — | 427 | 0.278 | — | — | „ |
| | CD 244 | „ | „ | „ | „ | 100 | — | — | „ | „ | 100 | „ | — | — | 350 | 0.255 | — | — | „ |
| | CUD240 | „ | „ | none | — | 80 | — | — | „ | „ | „ | „ | — | — | 375 | 0.144 | — | — | „ |
| | FUD235 | „ | ME(260)·DWC(20) | 20 | D | 44 | — | — | „ | „ | „ | „ | — | — | 500 | 0.291 | 489 | 11.0 | „ |
| | FUD268 | „ | „ | „ | „ | 30 | — | — | „ | „ | „ | „ | — | — | „ | 0.311 | 441 | 11.4 | „ |
| | FUD266 | „ | „ | „ | „ | 58 | — | — | „ | „ | 20 | .5 | — | — | 621 | 0.212 | — | — | „ |
| | FD 263 | „ | „ | 80 | 4.4 | 40 | — | — | „ | „ | 100 | 1 | — | — | 300 | 0.171 | — | — | „ |
| | DUD 97 | 75 | ME(210)·DAC | none | D | 35 | 148 | 130 | 140 | 1 | 60 | 1 | — | — | 171 | 0.126 | 177 | 5.5 | „ |
| | DUD 94 | „ | „ | „ | „ | 43 | „ | „ | „ | „ | „ | „ | — | — | 333 | 0.193 | 222 | 8.4 | „ |
| | DUD 93 | „ | „ | „ | „ | 44 | „ | „ | „ | „ | „ | „ | — | — | 364 | 0.258 | 533 | 7.1 | „ |
| | DUD 95 | „ | „ | „ | „ | 38 | „ | „ | „ | „ | „ | „ | — | — | 474 | 0.301 | 514 | 9.8 | „ |
| | DUD 99 | „ | „ | „ | „ | 36 | „ | „ | „ | „ | 20 | „ | — | — | 528 | 0.281 | 543 | 9.3 | „ |
| | DUD 48 | „ | „ | „ | „ | 34 | „ | „ | „ | „ | 130 | „ | — | — | 382 | 0.285 | 394 | 12.5 | „ |
| | PD 47 | „ | HP(250)·AC | 70 | 2.5 | 50 | „ | „ | none | — | „ | „ | — | — | 200 | 0.104 | 200 | 9.2 | „ |
| | CDU109 | „ | SC·VD | none | — | 51 | — | — | 140 | 1 | 120 | „ | — | — | 275 | 0.196 | 275 | 7.5 | „ |

0 037 877

TABLE 11

| I | II | III | IV | | V | VI | | VII | | VIII | | IX | | X | | XI | | XII |
|---|----|-----|----|---|---|----|---|-----|---|------|---|----|---|---|---|----|---|-----|
| | | | A | B | | A | B | A | B | A | B | A | B | A | B | A | B | |
| FD 124 | 79 | ME(290) · DC(65) | 125 | 2.5 | 72 | 145 | none | 143 | 1 | 140 | 1 | 148 | 134 | 417 | 0.151 | 429 | 12.8 | YES |
| PD 127 | ,, | HP(240) · IWC | 80 | 3.9 | 47 | 147 | 129 | 140 | ,, | 120 | ,, | — | — | 319 | 0.196 | 208 | 8.4 | ,, |
| PD 135 | ,, | ,, | ,, | ,, | 50 | ,, | ,, | 142 | ,, | 100 | ,, | — | — | 360 | 0.230 | 333 | 12.5 | ,, |
| PUD282 | ,, | HP(260) · WC(40) | none | — | 75 | 143 | none | 143 | ,, | ,, | .5 | 147 | 139 | 467 | 0.150 | — | — | ,, |
| PUD287 | ,, | HP(270) · AC | ,, | ,, | 61 | 149 | 135 | 141 | ,, | ,, | ,, | — | — | 748 | 0.241 | — | — | ,, |
| CD 131 | ,, | SC · VD | 80 | 4.5 | 28 | 148 | (128) | 143 | ,, | 80 | ,, | 149 | 139 | 393 | 0.278 | 367 | 7.2 | ,, |
| CD 132 | ,, | ,, | ,, | ,, | 29 | ,, | ,, | ,, | ,, | 65 | ,, | ,, | ,, | 483 | 0.271 | — | — | ,, |
| CD 149 | ,, | ,, | 100 | 5.9 | 30 | — | — | 140 | ,, | 100 | ,, | — | — | 333 | 0.241 | 333 | 9.6 | ,, |
| CUD128 | ,, | ,, | none | — | 81 | 144 | 122 | ,, | ,, | ,, | ,, | — | — | 284 | 0.193 | 250 | 7.2 | ,, |
| CUD177 | ,, | ,, | ,, | ,, | 95 | ,, | ,, | ,, | ,, | ,, | ,, | — | — | 326 | 0.254 | 337 | 8.2 | ,, |
| CUD216 | ,, | ,, | ,, | ,, | 66 | ,, | ,, | 130 | ,, | ,, | ,, | — | — | 348 | 0.182 | 338 | 7.3 | ,, |
| UD 218 | ,, | ,, | ,, | ,, | ,, | ,, | ,, | 110 | ,, | ,, | ,, | — | — | 343 | <0.01 | 348 | 6.2 | NO |
| CUD215 | ,, | ,, | 80 | 5 | 36 | 148 | 128 | 140 | ,, | ,, | ,, | — | — | 351 | 0.310 | 361 | 9.7 | YES |
| PUD290 | ,, | HP(250) · AC(140) | none | — | 70 | — | — | ,, | ,, | ,, | ,, | — | — | 643 | 0.248 | — | — | ,, |

TABLE 12

| I | II | III | IV | | V | VI | | VII | | VIII | | IX | | X | | XI | | XII |
|---|---|---|---|---|---|---|---|---|---|---|---|---|---|---|---|---|---|---|
| | | | A | B | | A | B | A | B | A | B | A | B | A | B | A | B | |
| CD 144 | 80 | SC·VD | 80 | 5.1 | 31 | — | — | 144 | 1 | 100 | 1 | — | — | 387 | 0.060 | 387 | 12.5 | YES |
| CDU146 | „ | „ | none | — | 151 | — | — | 140 | „ | „ | „ | — | — | 185 | 0.092 | 167 | 5.2 | „ |
| CDU294 | „ | „ | „ | „ | 60 | — | — | 142 | „ | „ | „ | — | — | 495 | 0.151 | — | — | „ |
| CDU147 | 82 | SC·VD | none | — | 67 | — | — | 140 | 1 | 100 | 1 | — | — | 441 | 0.060 | 385 | 3.5 | „ |
| PUD288 | „ | HP(288)·AC | „ | „ | 66 | 151 | 123 | 150 | „ | „ | „ | — | — | 530 | 0.050 | — | — | „ |
| PD 62 | „ | HP(250)·RD(120) | 120 | 3 | 91 | 166 | none | 140 | | 115 | „ | 162 | 149 | 440 | 0.161 | 400 | 6.7 | „ |
| CP 277 | 72/79 | SC·VD | 83 | 5.8 | 44 | 148 | (177) | 140 | 1 | 100 | .5 | 149 | 128 | 500 | 0.285 | — | — | „ |
| CUD276 | „ | „ | none | — | 113 | 145 | (113) | „ | „ | „ | „ | „ | 126 | 354 | 0.189 | — | — | „ |

## Claims

1. A piezoelectric polymer material consisting solely or mainly of a copolymer solely or mainly of vinylidene fluoride and ethylene trifluoride, characterized in that the copolymer consists solely or mainly of 65—82 mol % of vinylidene fluoride and 35—18 mol % of ethylene trifluoride and the value of the thickness extensional electromechanical coupling factor ($K_t$) of the material is at least 0.05.

2. A piezoelectric polymer material as claimed in Claim 1 in which the thickness extensional electromechanical coupling factor ($K_t$) is not less than 0.1.

3. A piezoelectric polymer material as claimed in Claim 2 in which the thickness extensional electromechanical coupling factor ($K_t$) is not less than 0.2.

4. A process for producing a piezoelectric polymer material which consists solely or mainly of a copolymer consisting solely or mainly of vinylidene fluoride and ethylene trifluoride by heat treating and poling, characterized in that it comprises as a first step only heat-treating a shaped article consisting solely or mainly of a copolymer consisting solely or mainly of 65—82 mol % of vinylidene fluoride and 35—18 mol % of ethylene trifluoride at a heat-treating temperature T(°C) being in the range of from [crystal phase transition temperature $T_m'$ (°C) — 5 (°C)] to [melting point temperature $T_m$ (°C)] and as a second step only poling the heat-treated shaped article.

5. A process for producing a piezoelectric polymer material as claimed in Claim 4 in which the heat-treating temperature T(°C) is in the range of from $T_m'$ (°C) to $T_m$ (°C).

6. A process for producing a piezoelectric polymer material as claimed in Claim 4 in which the copolymer consists of 70—82 mol % of vinylidene fluoride and 30—18 mol % of ethylene trifluoride.

7. A process for producing a piezoelectric polymer material which consists solely or mainly of a copolymer consisting solely or mainly of vinylidene fluoride and ethylene trifluoride by heat-treating and poling, characterized in that it comprises heat-treating a shaped article consisting solely or mainly of a copolymer consisting solely or mainly of 65—82 mol % of vinylidene fluoride and 35—18 mol % of ethylene trifluoride at a heat-treating temperature T (°C) being in the range of from [crystal phase transition temperature $T_m'$ (°C) — 5 (°C)] to [melting point temperature $T_m$ (°C)] while poling the shaped article.

8. A process for producing a piezoelectric polymer material as claimed in Claim 7 in which the heat-treating temperature T (°C) is in the range of from $T_m'$ (°C) to $T_m$ (°C).

9. A process for producing a piezoelectric polymer material as claimed in Claim 7 in which the copolymer consists of 70—82 mol % of vinylidene fluoride and 30—18 mol % of ethylene trifluoride.

10. An ultrasonic transducer including a piezoelectric vibrating element comprising a piezoelectric sheet consisting solely or mainly of a copolymer consisting solely or mainly of 65—82 mol % of vinylidene fluoride and 35—18 mol % of ethylene trifluoride having the value of the thickness extentional electromechanical coupling factor ($K_t$) of at least 0.05.

11. An ultrasonic transducer as claimed in Claim 10 in which the thickness extentional electromechanical coupling factor ($K_t$) is not less than 0.1.

12. An ultrasonic transducer as claimed in Claim 11 in which the thickness extentional electromechanical coupling factor ($K_t$) is not less than 0.2.

## Revendications

1. Matériau polymère piézoélectrique, composé entièrement ou principalement d'un copolymère constitué entièrement ou principalement de fluorure de vinylidène et de trifluorure d'éthylène, caractérisé en ce que le copolymère comprend entièrement ou principalement 65—82% en mole de fluorure de vinylidène et 35—18% en mole de trifluorure d'éthylène, et la valeur du facteur de couplage électromécanique en extension dans le sens de l'épaisseur ($K_t$) du matériau est au moins 0,05.

2. Matériau polymère piézoélectrique selon la revendication 1, dans lequel le facteur de couplage électromécanique en extension dans le sens de l'épaisseur ($K_t$) n'est pas inférieur à 0,1.

3. Matériau polymère piézoélectrique selon la revendication 2, dans lequel le facteur de couplage électromécanique en extension dans le sens de l'épaisseur ($K_t$) n'est pas inférieur à 0,2.

4. Procédé de fabrication d'un matériau polymère piézoélectrique composé entièrement ou principalement d'un copolymère constitué entièrement ou principalement de fluorure de vinylidène et de trifluorure d'éthylène par traitement thermique et formation de pôles, caractérisé en ce qu'il comprend comme première étape seulement le traitement thermique d'un article façonné composé entièrement ou princaplement d'un copolymère constitué entiérement ou principalement de 65—82% en mole de fluorure de vinylidène et de 35—18% en mole de trifluorure d'éthylène à une température de traitement thermique T (°C) comprise dans la plage allant de la température de transition de phase cristalline $T_m'$ (°C) — 5 (°C) et la température du point de fusion $T_m$ (°C), et comme seconde étape seulement la formation de pôles dans l'article façonné, traité thermiquement.

5. Procédé de fabrication d'un matériau polymère piézoélectrique selon la revendication 4, dans lequel la température de traitement thermique T (°C) est comprise dans la plage allant de $T_m'$ (°C) à $T_m$ (°C).

6. Procédé de fabrication d'un matériau polymère piézoélectrique selon la revendication 4, dans lequel le copolymère comprend 70—82% en mole de fluorure de vinylidène et 30—18% en mole de trifluorure d'éthylène.

7. Procédé de fabrication d'un matériau polymère piézoélectrique composé entièrement ou principalement d'un copolymère constitué entièrement ou principalement de fluorure de vinylidène et de trifluorure d'éthylène par traitement thermique et formation de pôles, caractérisé en ce qu'il comprend le traitement thermique d'un article façonné constitué entièrement ou principalement d'un copolymère comportant entièrement ou principalement 65—82% en mole de fluorure de vinylidène et 35—18% en mole de trifluorure d'éthlène à une température de traitement thermique T (°C) compris dans la plage allant de la température de transition de phase cristalline $T_m'$ (°C) — 5 (°C) et la température du point de fusion $T_m$ (°C) tout en formant des pôles dans l'article façonné.

8. Procédé de fabrication d'un matériau polymère piézoélectrique selon la revendication 7, dans lequel la température du traitement thermique T (°C) est comprise dans la plage allant de $T_m'$ (°C) à $T_m$ (°C).

9. Procédé de fabrication d'un matériau polymère piézoélectrique selon la revendication 7, dans lequel le copolymère est constitué de 70—82% en mole de fluorure de vinylidène et de 30—18% en mole de trifluorure d'éthylène.

10. Transducteur ultrasonique comprenant un élément vibrant piézoélectrique, constitué d'une feuille piézoélectrique comprenant entièrement ou principalement un copolymère constitué seulement ou principalement de 65—82% en mole de fluorure de vinylidène et 35—18% en mole de trifluorure d'éthylène ayant une valeur d'au moins 0,05 pour le facteur de couplage électromécanique en extension dans le sens de l'épaisseur ($K_t$).

11. Transducteur ultrasonique selon la revendication 10, dans lequel le facteur de couplage électromécanique en extension dans le sens de l'épaisseur ($K_t$) n'est pas inférieur à 0,1.

12. Transducteur ultrasonique selon la revendication 11, dans lequel le facteur de couplage électromécanique en extension dans le sens de l'épaisseur ($K_t$) n'est pas inférieur à 0,2.

## Patentansprüche

1. Piezoelektrisches Polymermaterial, bestehend allein oder hauptsächlich aus einem Kopolymer allein oder hauptsächlich von Vinylidenfluorid und Äthylentrifluorid, dadurch gekennzeichnet, daß das Kopolymer allein oder hauptsächlich aus 65—82 mol % Vinylidenfluorid und 35—18 mol % Äthylentrifluorid besteht und daß der Wert des elektromechanischen Dickenausdehnungs-Kopplungsfaktors ($K_t$) des Materials wenigstens 0,05 ist.

2. Piezoelektrisches Polymermaterial nach Anspruch 1, dadurch gekennzeichnet, daß der elektromechanische Dickenausdehnungs Kopplungsfaktor ($K_t$) nicht kleiner ist als 0.1.

3. Piezolelektrisches Polymermaterial nach Anspruch 2, dadurch gekennzeichnet, daß der elektromechanische Dickenausdehnungs-Kopplungsfaktor ($K_t$) nicht kleiner ist als 0,2.

4. Verfahren zur Herstellung eines piezoelektrischen Polymermaterials, das allein oder hauptsächlich aus einem Kopolymer allein oder hauptsächlich aus Vinylidenfluorid und Äthylentrifluorid besteht, durch Wärmebehandlung und Polung, dadurch gekennzeichnet, daß als erster Schritt nur eine Wärmebehandlung eines geformten Gegenstandes, der allein oder hauptsächlich aus einem Kopolymer allein oder hauptsächlich aus 65—82 mol % Vinylidenfluorid und 35—18 mol % Äthylentrifluorid besteht, bei einer Behandlungstemperatur, die im Bereich zwischen der Kristallphasenübergangstemperatur $T_m'$ (°C) — 5 (°C) und dem Schmelzpunkt $T_m$ (°C) liegt, und daß als ein zweiter Schritt nur die Polung des wärmebehandelten, geformten Gegenstandes durchgeführt wird.

5. Verfahren zum Herstellen eines piezoelektrischen Polymermaterials nach Anspruch 4, dadurch gekennzeichnet, daß die Wärmebehandlungstemperatur T (°C) im Bereich zwischen $T_m'$ (°C) und $T_m$ (°C) liegt.

6. Verfahren zum Herstellen eines piezoelektrischen Polymermaterials nach Anspurch 4, dadurch gekennzeichnet, daß das Kopolymer aus 70—82 mol % Vinylidenfluorid und 30—18 mol % Äthylentrifluorid besteht.

7. Verfahren zum Herstellen eines piezoelektrischen Polymermaterials, das allein oder hauptsächlich aus einem Kopolymer allein oder hauptsächlich aus Vinylidenfluorid und Äthylentrifluorid besteht, durch Wärmebehandlung und Polung, dadurch gekennzeichnet, daß ein geformter Gegenstand, der allein oder hauptsächlich aus einem Kopolymer allein oder hauptsächlich aus 65—82 mol % Vinylidenfluorid besteht, einer Wärmebehandlung bei einer Temperatur T (°C) unterzogen wird, die im Bereich zwischen der Kristallphasenübergangsperiode $T_m'$ (°C) — 5 (°C) und dem Schmelzpunkt $T_m$ (°C) liegt, während der geformte Gegenstand gepolt wird.

8, Verfahren zum Herstellen eines piezoelektrischen Polymermaterials nach Anspruch 7, dadurch gekennzeichnet, daß die Wärmebehandlungstemperatur T (°C) im Bereich zwischen $T_m'$ (°C) und $T_m$ (°C) liegt.

9. Verfahren zum Herstellen eines piezoelektrischen Polymermaterials nach Anspruch 7, dadurch gekennzeichnet, daß das Kopolymer aus 70—82 mol % Vinylidenfluorid und 30—18 mol % Äthylentrifluorid besteht.

10. Ultraschallwandler mit einem piezoelektrischen Schwingkörper, bestehend aus einer piezo-

**0 037 877**

elektrischen Platte allein oder hauptsächlich aus einem Kopolymer allein oder hauptsächlich aus 65—82 mol % Vinylidenfluorid und 35—18 mol % Äthylentrifluorid, dessen elektromechanischer Dickenausdehnungs-Kopplungsfaktor ($K_t$) einen Wert von wenigstens 0,05 hat.

11. Ultraschallwandler nach Anspruch 10, dadurch gekennzeichnet, daß der elektromechanische Dickenausdehnungs-Kopplungsfaktor ($K_t$) nicht kleiner als 0,1 ist.

12. Ultraschallwandler nach Anspruch 11, dadurch gekennzeichnet, daß der elektromechanische Dickenausdehnungs-Kopplungsfaktor ($K_t$) nicht kleiner als 0,2 ist.

28

Fig.2

Fig.1

0 037 877

Fig. 3

Poling temperature (°C)

Piezoelectric constant d₃₁ (10⁻¹² C/N)

--o-- Poling Voltage 200 kv/cm

--o-- Poling Voltage 240∼300 kv/cm

Fig. 4

## Fig. 5

Elastic constant $E_{11}'$ ($10^9$ N/m²) vs Poling temperature (°C)

--o-- Preheat-treatment at 140°C

—o—
—△— } Without preheat-treatment

$T_m'$ (130°C)

$T_m$ (148°C)

## Fig. 8

Fig. 7

Fig. 6

4

Fig. 9

Fig. 10

P(VDF-TrFE)
(75/25)
Thickness 34 μm
$k_t = 0.285$

Admittance |Y| (optional division)

Phase angle φ (degree)

Frequency (MHz)

*Fig. 11*

Fig. 12

Fig. 13